# EUROPEAN PATENT APPLICATION

(11) **EP 3 796 372 A1**
(43) Date of publication of application: **24.03.2021**
(21) Application number: 19833991.3
(22) Date of filing: 21.06.2019
(51) Int. Cl.: H01L 21/8239, C01B 19/04, H01L 27/105, H01L 45/00

(54) **LAMINATE STRUCTURE AND METHOD FOR MANUFACTURING SAME, AND SEMICONDUCTOR DEVICE**

(30) Priority: 10.07.2018 JP 2018130365
(71) Applicant: NATIONAL INSTITUTE OF ADVANCED INDUSTRIAL SCIENCE AND TECHNOLOGY, Chiyoda-ku Tokyo 100-8921 (JP); KABUSHIKI KAISHA TOSHIBA, Minato-ku Tokyo 105-0023 (JP)
(72) Inventor: TOMINAGA Junji, Tsukuba-shi, Ibaraki 305-8560 (JP); MIYATA Noriyuki, Tsukuba-shi, Ibaraki 305-8560 (JP); KAMATA Yoshiki, Tokyo 105-0023 (JP); KUNISHIMA Iwao, Tokyo 105-0023 (JP)
(74) Representative: Gille Hrabal Partnerschaftsgesellschaft mbB Patentanwälte
(86) International application number: PCT/JP2019/024679
(87) International publication number: WO 2020/012916

(57) **Abstract**

[Problem]: The problem of the present invention is to provide a stacked structure excellent in stability of atomic arrangement, a method of manufacturing same, and a semiconductor device using the stacked structure. [Solution]: The stacked structure of the present invention is characterized in that it has an alloy layer A having germanium and tellurium as a main component and an alloy layer B having tellurium and either of antimony or bismuth as a main component, and at least either of the alloy layer A or the alloy layer B contains at least either of sulfur or selenium as a chalcogen atom.

## Description

### Technical Field

The present invention relates to a stacked structure having two successively-stacked alloy layers, a method of manufacturing the structure, and a semiconductor device having the stacked structure.

### Background Art

In a conventional type phase-change memory using a tertiary alloy consisting of germanium (Ge), antimony (Sb), and tellurium (Te) (which will hereinafter be called "GST alloy"), a recording process called "SET" for changing a phase from a high-resistance-state amorphous phase to a low-resistance-state crystal phase and an erasing process called "RESET" for returning the crystal phase to the amorphous phase are achieved by changing the magnitude of a current pulse and an application time.

However, the above-described memory has had a drawback from the standpoint of power saving because in the erasing process, the amorphous phase should be formed by once injecting into the GST alloy a current large enough to generate a melting temperature or more (refer to Non-Patent Documents 1 and 2).

To overcome the above problem, there is proposed a stacked structure type phase-change memory using a stacked structure obtained by alternately stacking, in a crystalline state, a GeTe alloy layer having a thickness of about 1 nm and an SbTe alloy layer having a thickness of from 1 nm to 4 nm (refer to Patent Document 1 and Non-patent Document 3).

According to this proposal, power can be reduced to one tenth or less of the conventional memory by adding a current pulse to the stacked structure to generate a low-resistance-state first crystal phase (SET phase) and a high-resistance-state second crystal phase (RESET phase) and thereby achieving a crystal-crystal phase transition at a temperature less than the melting temperature of the component alloy, in other words, without increasing it to the melting temperature.

However, several problems to be solved are posed about the stacked structure type phase-change memory. They will hereinafter be described, along with the specific constitution of the stacked structure type phase-change memory.

The recording principle of the stacked structure type phase-change memory is to exchange the valence of a Ge atom present in the GeTe alloy layer with the position of a Te atom adjacent thereto to move back and forth the high-resistance-state crystal phase and the low-resistance-state crystal phase and thereby provide an ON-OFF state.

In the GeTe alloy layer, Ge atoms and Te atoms form uneven atomic layers in which they are arranged perpendicularly and alternately, one of the atomic layers having a thickness of about 0.4 nm.

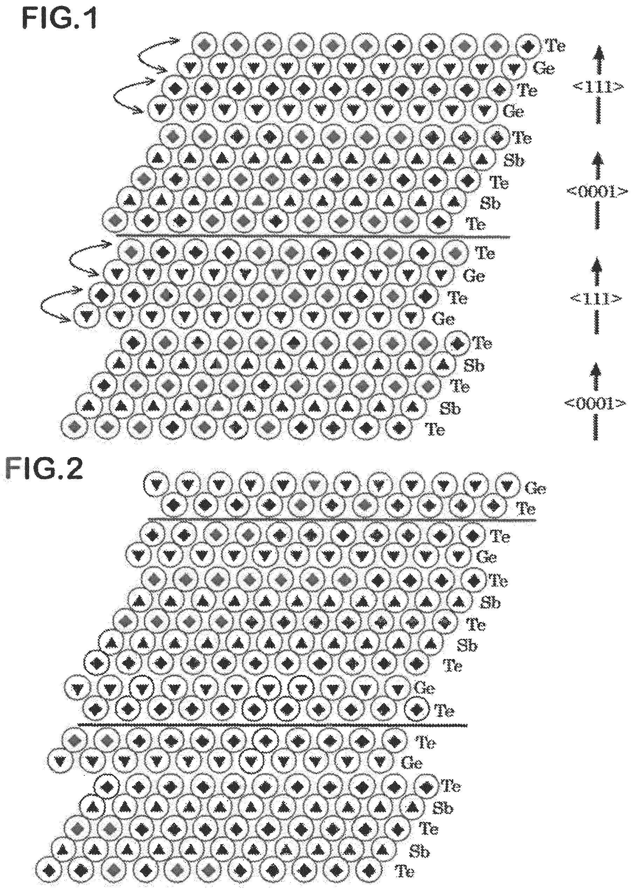

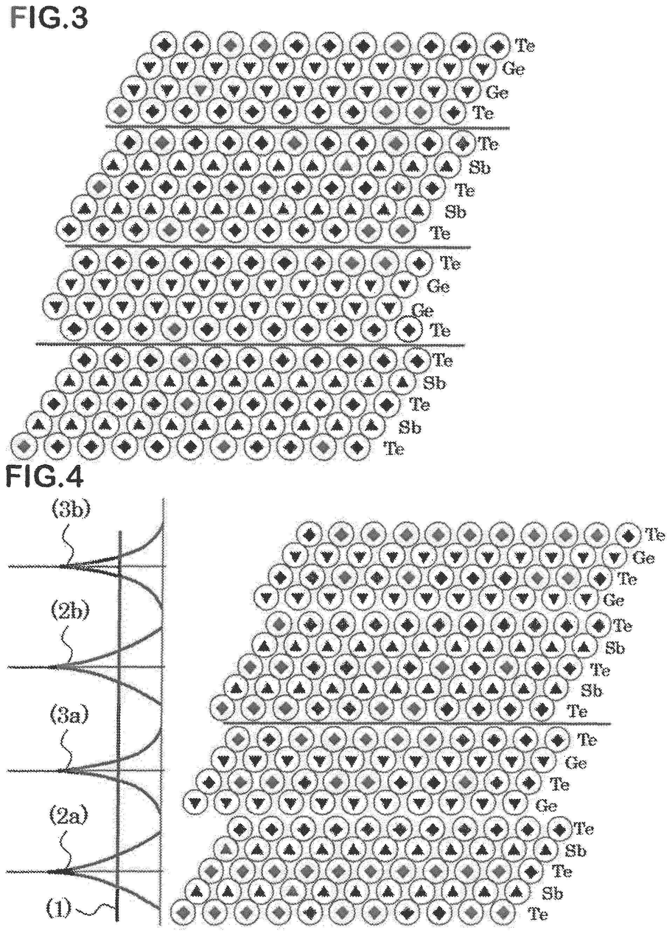

The GeTe alloy layer having these two atomic layers stacked successively can take four different arrangements, depending on an arrangement manner in the layer thickness direction. More specifically, there are following four different arrangements in the thickness direction from the bottom surface side of the layer: a Ge-Te-Ge-Te arrangement (refer to FIG. 1), a Te-Ge-Te-Ge arrangement which is an arrangement inverse thereto (refer to both arrows in FIG. 1), a Ge-Te-Te-Ge arrangement (refer to FIG. 2), and a Te-Ge-Ge-Te arrangement (refer to FIG. 3). In particular, the Ge-Te-Ge-Te arrangement (refer to FIG. 1) can grow and increase the number of repetitions such as Ge-Te-Ge-Te-Ge-Te..., the crystal structure of which is cubic (refer to Non-patent Document 4).

FIG. 1 is a schematic view (1) showing an example of a low-resistance-state stacked structure, FIG. 2 is a schematic view (2) showing an example of a low-resistance-state stacked structure, and FIG. 3 is a schematic view showing an example of a high-resistance-state stacked structure. In these drawings, "◆" represents a Te atom, "▼" represents a Ge atom, and "▲" represents an Sb atom, which will be applied equally to the following drawings.

It is known that among the SbTe alloy layers of the stacked structure, an Sb₂Te₃ alloy layer having a composition ratio of Sb₂Te₃ has a particularly stable structure and has a monolayer structure having five atomic layers stacked one after another (refer to FIGS. 1 to 3).

The Sb₂Te₃ alloy layer has a Te-Sb-Te-Sb-Te arrangement in the thickness direction from the bottom surface side of the layer, as shown in FIGS. 1 to 3. The Sb₂Te₃ alloy layer has a hexagonal crystal structure, with the Te atom and the Sb atom in the layer being bound strongly to each other by covalent bonding (refer to Non-patent Document 4).

It is to be noted that the five atomic layers serving as a component unit of the Sb₂Te₃ alloy layer will hereinafter be called "QL" (quintuple layer).

The GeTe alloy layer and the Sb₂Te₃ alloy layer compose the stacked structure, for example, by stacking them alternately in repetition with aligning their crystal axes. More specifically, the stacked structure is composed by sharing the <111> crystal face of the GeTe alloy layer and the <0001> crystal face of the Sb₂Te₃ alloy layer (refer to FIG. 1).

In the GeTe alloy layer and the Sb₂Te₃ alloy layer, Te atoms are bound weakly to each other by Van der Waals bonding (refer to Patent Document 1 and Non-patent Document 4) and analysis results of an actually created stacked structure based on a cross-section transmission electron micrograph have already been reported (refer to Non-patent Document 5).

The horizontal lines in FIGS. 1 to 3 each show the interface on which the Van der Waals bonding acts and this will be equally applied to the following drawings.

The stacked structure is formed using a vacuum film formation apparatus.

The film is formed in a certain order and it is necessary to form a thin Sb₂Te₃ alloy layer first on a substrate. The Sb₂Te₃ alloy layer is preferably formed as 3QL to 5QL. This makes it possible to form a clear stacked film (refer to Patent Document 1).

The Sb₂Te₃ alloy layer thus formed has, at the end thereof, a Te atomic surface. When the GeTe alloy layer is stacked successively thereon, an atomic layer having a Ge-Te-Ge-Te arrangement, a Te-Ge-Te-Ge arrangement, a Ge-Te-Te-Ge arrangement, and a Te-Ge-Ge-Te arrangement is formed in the layer thickness direction from the side of the Te atom surface. It is known that according to the calculation of thermodynamic phase stability, a phase transition temperature exists around about 230°C and the Te-Ge-Ge-Te phase is stable at this temperature or less and the Ge-Te-Ge-Te phase is stable at this temperature or more. It is also known that the Ge-Te-Te-Ge phase as well as the Te-Ge-Ge-Te phase is formed within a range from the vicinity of 160°C to room temperature (refer to Non-patent Document 5).

The stacked structure is formed from a repeated structure of these basic constitutions.

It is reported that the stacked structure having many Ge-Te-Ge-Te phases (refer to FIG. 1), Te-Ge-Te-Ge phases and Ge-Te-Te-Ge phases (refer to FIG. 2) has low electrical resistance from 1 kΩ to 10 kΩ, while the stacked structure having many Te-Ge-Ge-Te phases (refer to FIG. 3) has high electrical resistance from 1 MΩ to 10 MΩ (refer to Non-patent Document 6).

The memory operation of the stacked structure type phase-change memory is achieved by causing a phase change between these phases.

Research and development of the stacked structure type phase-change memory have been currently active in many countries around the world. With the progress in the field of analysis of raw materials, the following problems have been reported.

First, it has been reported that as analysis results using a high-resolution scanning transmission electron microscope capable of analyzing at an atomic level, a structure arrangement having many Sb atoms at a position where Ge atoms should be located is observed due to mutual diffusion between the QL and the GeTe alloy layer (refer to Non-patent Document 7). The Sb atoms located as a result of substitution are not involved in the phase change necessary for the memory operation, so that when the number of Ge atoms of the GeTe alloy layer is reduced by the substitution to Sb atoms, a change in electrical resistance due to the phase change gradually decreases and no memory operation can be performed.

Next, it has been reported that as a result of observation, with a high-resolution scanning transmission electron microscope, of a stacked structure obtained by stacking a Ge₂Te₂ layer and an Sb₂Te₃ layer in repetition, some Ge atoms move to a position different from the position where they should be located, preventing from getting accurate positional information of the Ge atoms (refer to Non-patent Document 8). This phenomenon is caused by the interatomic transfer of Ge atoms and Sb atoms caused by absorption of the energy of electron beam irradiated on the stacked structure when the structure is observed with the scanning transmission electron microscope. This means that the atomic arrangement of the stacked structure necessary for the memory operation is easily broken by the external energy thus absorbed.

### Prior Art Documents

### Patent Documents

Patent Document 1: Japanese Patent No. 4621897

### Non-patent Documents

Non-patent Document 1: S. Raoux and M. Wuttig, Phase Change Materials, Springer Verlag (2009).
Non-patent Document 2: M. Wuttig and N. Yamada, Nature Mater. 6, 824-832 (2007).
Non-patent Document 3: R. Simpson, P. Fons, A. V. Kolobov, T. Fukaya, M. Krbal, T. Yagi, and J. Tominaga, Nature Nanotechnol. 6, 501 (2011).
Non-patent Document 4: J. Tominaga, A. V. Kolobov, P. Fons, T. Nakano and S. Murakami, Adv. Mater. Interfaces 2013, DOI: 10.1002/admi.201300027
Non-patent Document 5: J. Tominaga, A. V. Kolobov, P. J. Fons, X. Wang, Y. Saito, T. Nakano, M. Hase, S. Murakami, J. Herfort, Y. Takagaki, Sci. Technol. Adv. Mater. 16, 014402, 2015.
Non-patent Document 6: H. Nakamura, I. Rugger, S. Sanvito, N. Inoue, J. Tominaga and Y. Asai, Nanoscale, 9, 9386 - 9395, 2017.
Non-patent Document 7: Ruining Wang, Valeria Bragaglia, Jos E. Boschker, and Raffaella Calarco, Cryst. Growth 16, 3596 - 3601 (2016).
Non-patent Document 8: Andriy Lotnyk, Isom Hilmi, Ulrich Ross, and Bernd Rauschenbach, Nano Research, 11, 1676 - 1686, 2018.

### Disclosure of the Invention

### Problems to be solved by the Invention

An object of the present invention is to solve the above-described various conventional problems and achieve the following object. That is, the object of the present invention is to provide a stacked structure excellent in stability of atomic arrangement, a method of manufacturing the structure, and a semiconductor device using the stacked structure.

As a result of an intensive investigation for solving the above problems, the present inventors have the following findings.

The stacked structure loses its phase-change function because Ge atoms which are in the GeTe alloy layer and involved in a phase change diffuse to the QL side.

Between the GeTe alloy layer and the QL in a memory of the stacked structure, there are concentration gradients of Ge atoms and Sb atoms, which are atoms other than Te atoms, with their interface as a boundary and a chemical potential between them occurs due to the concentration gradient. Mutual diffusion therefore occurs easily to the respective sides where Ge atoms and Sb atoms each should not be located (refer to FIG. 4).

FIG. 4 is an explanatory view (A) for explaining the mutual diffusion of Ge atoms and Sb atoms, in which (1) shows the chemical potential of Te atoms, (2a) shows the chemical potential of Sb atoms in the QL shown on the lower side of the drawing, (2b) shows the chemical potential of Sb atoms in the QL shown on the upper side of the drawing, (3a) shows the chemical potential of Ge atoms in the GeTe alloy layer shown on the lower side of the drawing, and (3b) shows the chemical potential of Ge atoms in the GeTe alloy layer shown on the upper side of the drawing.

When the stacked structure absorbs external energy such as energy necessary for a phase change or energy of an electron beam irradiated during observation with the scanning transmission electron microscope, a Te-Sb bond in the QL is released first and Sb atoms in the QL diffuse to the GeTe alloy layer. This occurs because Te-Sb bond dissociation energy is smaller by about 120 kJ/mol than Ge-Te bond dissociation energy as shown below in Table 1.

When the Sb atoms in the QL diffuse to the GeTe alloy layer, the Ge-Te bond in the GeTe alloy layer is dissociated through the inducement of this diffusion, resulting in diffusion of the Ge atoms in the GeTe alloy layer to the QL. This occurs because the chemical potential corresponding to that of the Ge atoms in the GeTe alloy layer before mutual diffusion decreases through the inducement of a reduction in the chemical potential of the Sb atoms in the QL due to a reduction in the concentration gradient and action works to keep the free energy of the whole system of the stacked structure lower.

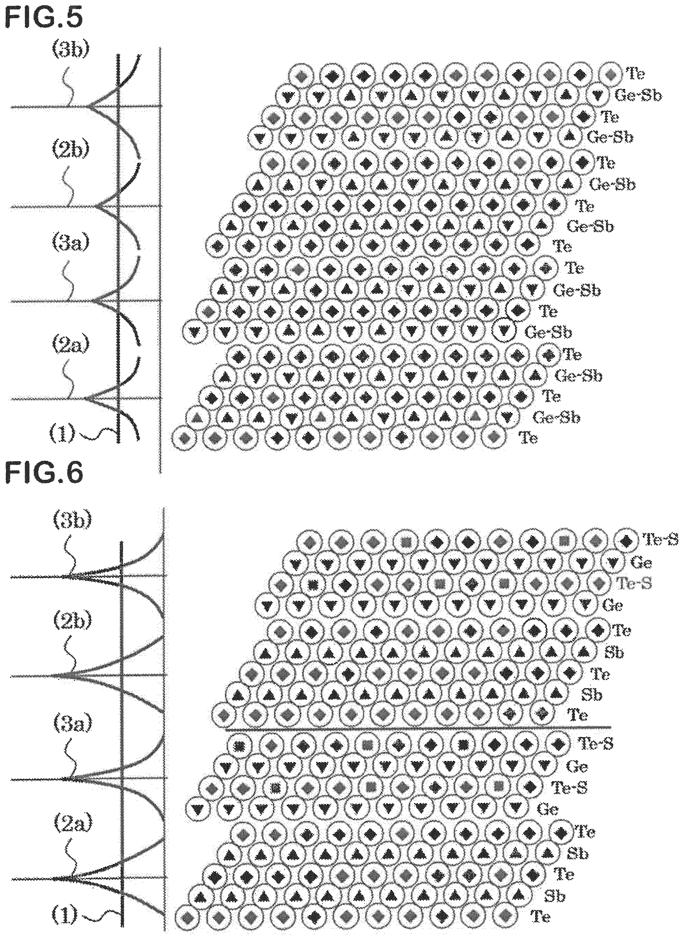

As a result, there occurs mutual diffusion-induced substitution of Ge atoms and Sb atoms between the GeTe alloy layer and the QL (refer to FIG. 5).

In addition, the mutual diffusion between Sb atoms and Ge atoms causes disappearance of spaces between Te atoms which have appeared at the interface between the Te atoms as a result of weak bonding due to Van der Waals bonding (refer to FIGS. 1 to 3) (refer to FIG. 5).

FIG. 5 is an explanatory view (B) for explaining the mutual diffusion of Ge atoms and Sb atoms, in which (1) shows the chemical potential of Te atoms, (2a) shows the chemical potential corresponding to that of Sb atoms before mutual diffusion in the QL shown on the lower side of the drawing, (2b) shows the chemical potential corresponding to that of Sb atoms before mutual diffusion in the QL shown on the upper side of the drawing, (3a) shows the chemical potential corresponding to Ge atoms before mutual diffusion in the GeTe alloy layer shown on the lower side of the drawing, and (3b) is the chemical potential corresponding to that of Ge atoms before mutual diffusion in the GeTe alloy layer shown on the upper side of the drawing. This drawing shows that due to a reduction in concentration gradient, each of the chemical potentials becomes smaller than that before mutual diffusion.

Table 1 shown below is a table showing bond dissociation energy between two atoms and it is based on the following Reference Document 1.

Reference Document 1: Luo, Y. R., Comprehensive Handbook of Chemical Bond Energies, CRC Press, Boca Raton, FL, 2007.

**[Table 1]**

| Two atoms | Bond dissociation energy (kJ/mol) |
|---|---|
| Ge-Ge | 264.4 ± 6.8 |
| Ge-S | 534 ± 3 |
| Ge-Se | 484.7 ± 1.7 |
| Ge-Te | 396.7 ±3.3 |
| Sb-S | 378.7 |
| Te-S | 335 ± 42 |
| Te-Sb | 277.4 ± 3.8 |

In the bond between Ge atoms and S atoms which are chalcogen atoms belonging to Group 16 to which Te atoms also belong, Ge-S bond dissociation energy is about two times higher than Te-Sb bond dissociation energy and therefore the bond between Ge atoms and S atoms needs more dissociation energy than that between Te atoms and Ge atoms (refer to the above Table 1). The bond between Ge atoms and Se atoms which are also chalcogen atoms is not dissociated more easily than that between Te atoms and Ge atoms according to the comparison of the bond dissociation energy (refer to the above Table 1).

This suggests that diffusion of Ge atoms to the QL side can be suppressed more by introducing S atoms and Se atoms into the GeTe alloy layer and substituting some of Te atoms with the S atoms and Se atoms to form Ge-S bonds and Ge-Se bonds than without substitution. In other words, diffusion of Ge atoms to the QL side can be suppressed by keeping the high concentration gradient of Ge atoms and Sb atoms based on strong Ge-S bonds and Ge-Se bonds (refer to FIG. 6).

FIG. 6 is an explanatory view (C) for explaining the mutual diffusion of Ge atoms and Sb atoms, in which (1) shows the chemical potential of Te atoms, (2a) shows the chemical potential of Sb atoms in the QL shown on the lower side in the drawing, (2b) is the chemical potential of Sb atoms in the QL shown on the upper side in the drawing, (3a) is the chemical potential of Ge atoms in the GeTe alloy layer shown on the lower side in the drawing, and (3b) is the chemical potential of Ge atoms in the GeTe alloy layer shown on the upper side in the drawing. S atoms are used as an example of atoms to be introduced and in this drawing, S atoms are represented by "■".

In addition, the bond between Sb atoms and S atoms is more resistant to dissociation than that between Sb atoms and Te atoms according to the comparison of bond dissociation energy (refer to the above Table 1). The bond between Sb atoms and Se atoms is also more resistant to dissociation than that between Sb atoms and Te atoms.

This therefore suggests that also by introducing S atoms and Se atoms into the QL and substituting some of Te atoms with the S atoms and Se atoms to form Sb-S bonds and Sb-Se bonds, diffusion of Ge atoms in the GeTe alloy layer to the QL side can be suppressed more than without substitution.

This means that since the diffusion of Ge atoms in the GeTe alloy layer to the QL is induced by the diffusion of Sb atoms in the QL layer to the side of the GeTe alloy layer, the diffusion of Ge atoms in the GeTe alloy layer to the QL side can also be suppressed by forming Sb-S bonds and Sb-Se bonds to suppress the diffusion of Sb atoms in the QL to the side of the GeTe alloy layer.

The above description uses the SbTe alloy layer as an example, but a similar description can also be applied to a BiTe alloy layer using Bi atoms which belong to Group 15 to which Sb atoms belong.

The above description uses the stacked structure phase-change memory as an example, but a similar description can also be applied to a semiconductor device insofar as its device operation is performed by making use of the phase change of the stacked structure.

### Means for solving the Problems

The present invention is based on the above findings and means for solving the problems are shown below.
<1> A stacked structure including an alloy layer A having germanium and tellurium as a main component thereof, and an alloy layer B having tellurium and either of antimony or bismuth as a main component thereof, in which at least either of the alloy layer A or the alloy layer B contains at least either of sulfur or selenium as a chalcogen atom.
<2> The stacked structure as described above in <1> in which the chalcogen atom is contained in the alloy layer A.
<3> The stacked structure as described above in either of <1> or <2>, in which a chalcogen content of the alloy layer A is from 0.05 at% to 10.0 at%.
<4> The stacked structure as described above in any of <1> to <3>, having the alloy layer A and the alloy layer B stacked alternately in repetition.
<5> The stacked structure as described above in any of <1> to <4>, in which the alloy layer A has a cubic crystal structure and the alloy layer B has a hexagonal crystal structure, the alloy layer A is stacked over the alloy layer B, the alloy layer B has a c axis oriented in a stacking direction, and the alloy layer A has a (111) face oriented to a surface adjacent to the alloy layer B.
<6> A method of manufacturing the stacked structure as described above in any of <1> to <5> having a step of heating each of the alloy layer A and the alloy layer B at a temperature of from 200°C to 300°C.
<7> A semiconductor device having the stacked structure as described above in any of <1> to <5>.

### Advantageous Effect of the Invention

The present invention can overcome the above-described various problems of the conventional art and can provide a stacked structure excellent in stability of atomic arrangement, a method of manufacturing the stacked structure, and a semiconductor device using the stacked structure.

### Brief Description of the Drawings

FIG. 1 is a schematic view (1) showing an example of a low-resistance-state stacked structure.
FIG. 2 is a schematic view (2) showing an example of another low-resistance-state stacked structure.
FIG. 3 is a schematic view showing an example of a high-resistance-state stacked structure.
FIG. 4 is an explanatory view (A) for explaining the mutual diffusion of Ge atoms and Sb atoms.
FIG. 5 is an explanatory view (B) for explaining the mutual diffusion of Ge atoms and Sb atoms.
FIG. 6 is an explanatory view (C) for explaining the mutual diffusion of Ge atoms and Sb atoms.

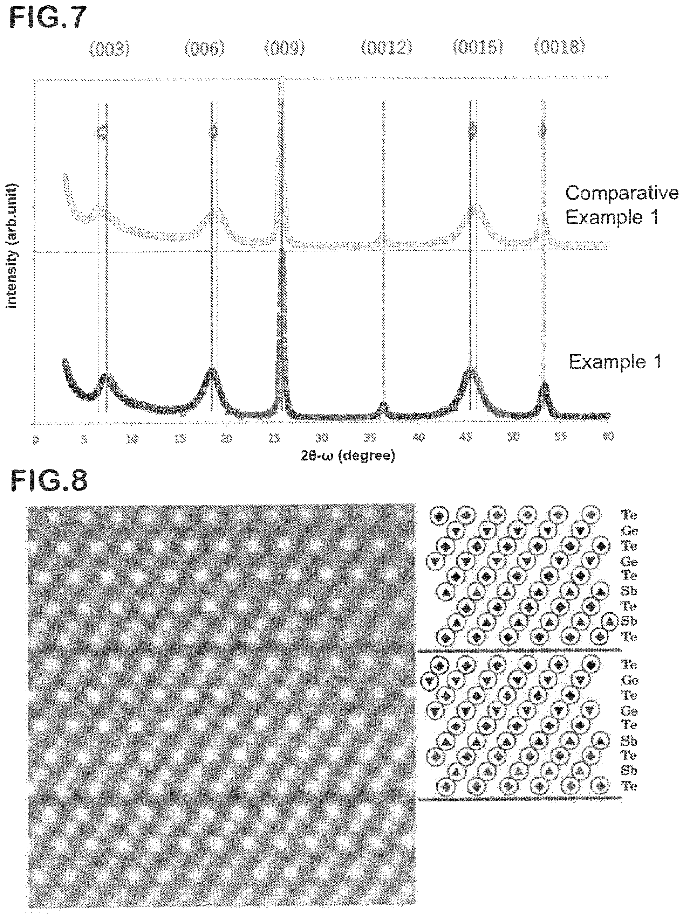

FIG. 7 shows an X-ray diffusion chart of respective stacked structures of Example 1 and Comparative Example 1.
FIG. 8 shows an electron microscope image of the stacked structure of Example 1.

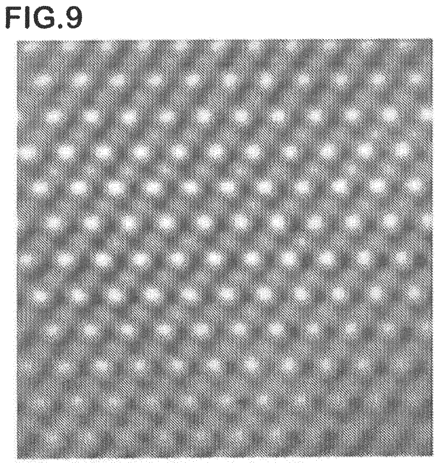

FIG. 9 shows an electron microscope image of the stacked structure of Comparative Example 1.

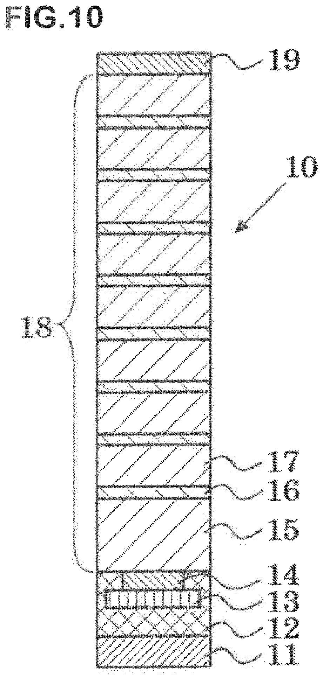

FIG. 10 is an explanatory view for explaining the constitution of a semiconductor device of Example 3.

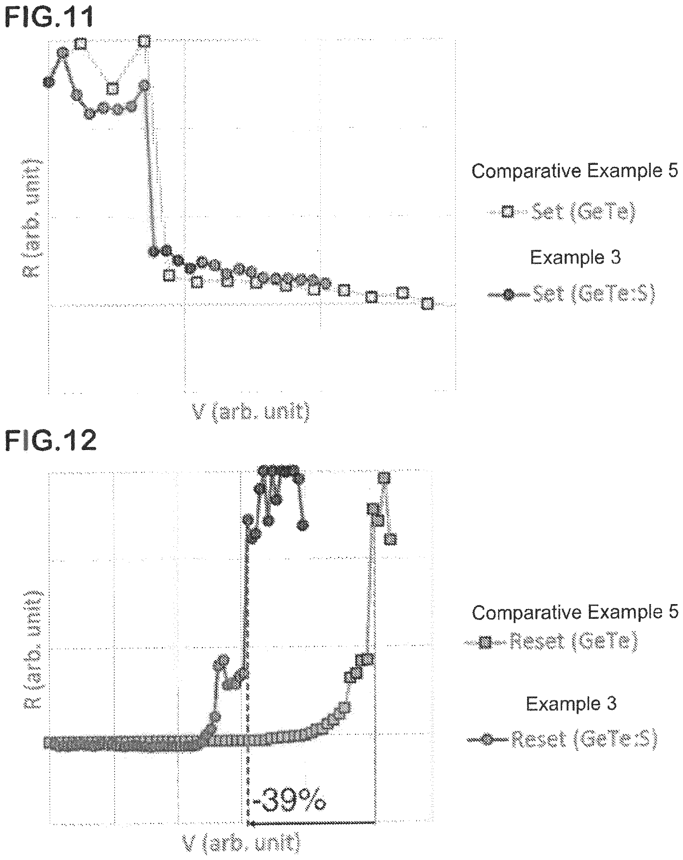

FIG. 11 shows voltage-electrical resistance characteristics of each of semiconductor devices of Example 3 and Comparative Example 5 from a high-resistance state (RESET phase) to a low-resistance state (SET phase).
FIG. 12 shows voltage-electrical resistance characteristics of each of semiconductor devices of Example 3 and Comparative Example 5 from a low-resistance state (SET phase) to a high-resistance state (RESET phase).

### Mode for carrying out the Invention

### (Stacked structure)

A stacked structure of the present invention has an alloy layer A and an alloy layer B.

### <Alloy layer A>

The alloy layer A is formed using germanium (Ge) and tellurium (Te) as a main component.

In the alloy layer A, atomic arrangement of germanium atoms and tellurium atoms gives the stacked structure two phases called "SET phase" and "RESET phase" different in properties and by applying a voltage to the stacked structure, phase transition occurs between these two phases.

The term "main component" as used herein means atoms forming an essential unit lattice of a layer. When the layer contains at least either of sulfur or selenium as chalcogen atoms (S atom, Se atom), the term means the chalcogen atoms (S atom, Se atom) and atoms forming the essential unit lattice.

Although the alloy layer A is not particularly limited, it is preferably a layer having a crystal direction oriented in a certain direction and particularly preferably a layer having a cubic crystal structure and at the same time, having a (111) face located on a surface adjacent to the alloy layer B. More preferably, it is a layer having a face-centered cubic crystal structure and at the same time, having a (111) face oriented to a surface adjacent to the alloy layer B.

If a layer has such a crystal structure, another layer stacked thereon becomes a template producing orientation with the first layer as an underlayer to facilitate the formation of a superlattice structure of these stacked layers.

A method of forming the alloy layer A is not particularly limited and it can be selected as needed depending on the purpose. Examples include sputtering, molecular beam epitaxy, ALD (Atomic Layer Deposition), and CVD (Chemical Vapor Deposition).

The thickness of the alloy layer A is not particularly limited and it is preferably more than 0 nm and not more than 4 nm. The layer having a thickness more than 4 nm sometimes shows its own inherent properties and has an influence on the properties of the stacked structure.

### <Alloy layer B>

The alloy layer B is formed using either of antimony (Sb) or bismuth (Bi) and tellurium (Te) as a main component.

The alloy layer B is not particularly limited. It includes a layer formed of SbTe or BiTe having an atomic composition ratio of 1:1 or a layer formed at another atomic composition ratio. Particularly preferably, it is made of either of Sb₂Te₃ or Bi₂Te₃ having an atomic composition ratio of 2:3 from the standpoint of stability of atomic arrangement.

The alloy layer B is not particularly limited. It is preferably a layer having a crystal direction oriented in a certain direction and more preferably a layer having a hexagonal crystal structure and at the same time, having a c axis oriented in a stacking direction.

If a layer has such a crystal structure, another layer stacked thereon becomes a template producing orientation with the first layer as an underlayer to facilitate the formation of a superlattice structure of these stacked layers.

A method of forming the alloy layer B is not particularly limited and it can be selected as needed depending on the purpose. Examples include sputtering, molecular beam epitaxy, ALD, and CVD.

The thickness of the alloy layer B is not particularly limited and it is preferably from 2 nm to 10 nm because such a thickness facilitates the formation of a c-axis-oriented crystal structure.

Although the stacked structure is not particularly limited, it has preferably a structure having the alloy layer A and the alloy layer B alternately stacked in repetition from the standpoint of causing phase transition more easily.

In this case, from the standpoint of forming a stacked structure having orientation, it is preferred to stack the alloy layer A over the alloy layer B with the alloy layer B as an underlayer (undermost layer) and repeat alternate stacking of the alloy layer A and the alloy layer B in this order. When the alloy layer B is located as the uppermost layer of the stacked structure, it functions as a layer preventing oxidation of the stacked structure.

The stacking number of layers for the stacked structure is not particularly limited and supposing that each of the alloy layer A and the alloy layer B is counted as one layer, the number may be from about 10 to 50.

From the standpoint of forming a stacked structure having orientation, it is also possible to use a substrate having, as an underlayer of the stacked structure, an orientation control layer formed of any of germanium, silicon, tungsten, germanium-silicon, germanium-tungsten, and silicon-tungsten and form the stacked structure on the orientation control layer.

### <Chalcogen atom>

In the stacked structure, at least either of the alloy layer A or the alloy layer B contains at least either of sulfur (S) or selenium (Se) as chalcogen atoms.

The structure containing the chalcogen atoms can not only suppress diffusion of Ge atoms from the alloy layer A to the side of the alloy layer B but also stabilize a phase change of the alloy layer A based on the atomic arrangement of Ge atoms and Te atoms.

The chalcogen atoms (S atom, Se atom) are substituted by Te atoms in each of the alloy layer A and the alloy layer B. Similar to the chalcogen atoms (S atom, Se atom), Te atoms belong to Group 16.

An excessively large substitution amount of Te atoms by the chalcogen atoms (S atom, Se atom), however, damages the phase transition-causing properties of the stacked structure, while an excessively small substitution amount makes it difficult to suppress diffusion of Ge atoms in the alloy layer A to the side of the alloy layer B.

A content of the chalcogen atoms in each of the alloy layer A and the alloy layer B is therefore preferably from 0.05 at% to 10.0 at%.

Although the chalcogen atoms may be contained in at least either of the alloy layer A or the alloy layer B, they are preferably contained in the alloy layer A from the standpoint of effectively suppressing diffusion of Ge atoms in the alloy layer A to the side of the alloy layer B. It is particularly preferred that their content in the alloy layer A is from 0.05 at% to 10.0 at%.

A method of forming each of the alloy layer A and the alloy layer B containing the chalcogen atoms is not particularly limited and it is possible to use any method capable of adding the chalcogen atoms to the formation materials of the alloy layer A and the alloy layer B and forming the alloy layer A and the alloy layer B.

### (Method of manufacturing stacked structure)

A method of manufacturing a stacked structure according to the present invention is a method of manufacturing the stacked structure of the present invention and it includes at least a step of heating each of the alloy layer A and the alloy layer B at a temperature of from 200°C to 300°C.

To the alloy layer A and the alloy layer B, the descriptions made on the stacked structure including the formation methods of them can be applied, but it is important to heat each of the alloy layer A and the alloy layer B at a temperature of from 200°C to 300°C.

This means that the stacked structure having excellent orientation can be obtained by heating at such a temperature.

### (Semiconductor device)

A semiconductor device according to the present invention is comprised of the stacked structure of the present invention.

The stacked structure can cause phase transition between two phases having respectively different properties, that is, the SET phase and the RESET phase and this phase transition phenomenon is useful for various devices. In particular, the chalcogen atoms contained in the structure enable it to stably exhibit the device properties which the original atomic arrangement has.

The semiconductor device is not particularly limited insofar as it has the stacked structure and examples include known phase-change devices and spin electronic devices disclosed in Japanese Patent No. 4599598, Japanese Patent No. 4621897 (Patent Document 1), Japanese Patent No. 5750791, Japanese Patent No. 6124320, Japanese Patent No. 6238495, and International Publication No. 2016/147802.

### Examples

### [Stacked structure]

### (Example 1)

First, a sapphire substrate (product of SHINKOSHA CO., LTD.) having a thickness of 200 pm was moved to a sputtering apparatus (4EP-LL, product of SHIBAURA MECHATRONICS CORPORATION, having 3 3-inch targets mounted thereon) and sputtering was performed with a silicon material (B-doped Si, product of Mitsubishi Materials Corporation) as a target under the following conditions: vacuum back pressure of 1.0 × 10⁻⁴ Pa, Ar film-formation gas pressure of 0.5 Pa, temperature of 25°C, and RF power of 100 W to form a 40-nm thick amorphous silicon layer as an underlayer on the sapphire substrate.

Next, sputtering was performed with an Sb₂Te₃ alloy material (product of Mitsubishi Materials Corporation, purity: 99.9%) as a target under the following conditions: Ar film-formation gas pressure of 0.5 Pa, temperature of 25°C, and RF power of 20 W while maintaining the vacuum back pressure to form a 3.0-nm thick Sb₂Te₃ alloy layer (first layer) on the amorphous silicon layer. After the formation, the Sb₂Te₃ alloy layer was crystallized by heating at 210°C.

Then, sputtering was performed using an S-atom-added GeTe alloy material (Ge₅₀Te₄₇S₃, product of Mitsubishi Materials Corporation, purity: 99.9%) as a target under the conditions of RF power of 20 W while maintaining the vacuum back pressure and the Ar-film formation gas pressure and keeping the temperature at 210°C to form a 0.8-nm thick GeTe alloy layer (first layer) having an S atom content of 3 at% on the Sb₂Te₃ alloy layer and crystallize it.

Then, an Sb₂Te₃ alloy layer and a GeTe alloy layer were stacked alternately in repetition under the conditions similar to those for the formation of the first layer, respectively, while maintaining the vacuum back pressure and Ar-film formation gas pressure and keeping the temperature at 210°C to form a stacked structure having a total of 20 layers stacked one after another, more specifically, having 10 Sb₂Te₃ alloy layers and 10 GeTe alloy layers stacked alternately. The thickness of the second and subsequent Sb₂Te₃ alloy layers, however, was changed from the first layer thickness, 3.0 nm, to 1.0 nm. This means that the first layer of the 10 Sb₂Te₃ alloy layers has a thickness of 3.0 nm and the second to tenth layers each have a thickness of 1.0 nm.

Finally, under conditions similar to those for the first layer except that the thickness was changed from 3.0 nm to 5.0 nm, an Sb₂Te₃ alloy layer was formed as an anti-oxidant layer on the GeTe alloy layer serving as the uppermost layer of the stacked structure and was crystallized.

Thus, a stacked structure of Example 1 was manufactured.

### (Comparative Example 1)

In a manner similar to that of Example 1 except for the use of an S-atom-free GeTe alloy material (product of Mitsubishi Materials Corporation, purity: 99.9%) as the target material instead of the S-atom-added GeTe alloy material (Ge₅₀Te₄₇S₃) to form an S-atom-free GeTe alloy layer, a stacked structure of Comparative Example 1 was manufactured.

### (Structural analysis)

X-ray analysis of each of the stacked structures of Example 1 and Comparative Example 1 was performed with an X-ray diffraction apparatus ("SmartLab", product of Rigaku Corporation) by a 2-theta/omega method.

FIG. 7 shows an X-ray diffraction chart of each of the stacked structures of Example 1 and Comparative Example 1.

The full width at half maximum (FWHM) at each of the diffraction peaks of (003), (006), (009), (0012), (0015), and (0018) shown in FIG. 7 is shown below in Table 2.

**[Table 2]**

| Diffraction peak | (003) | (006) | (009) | (0012) (0015) | | (0018) |
|---|---|---|---|---|---|---|
| Example 1 Full width at half maximum (FWHM) | 2.608886 | 2.025599 | 0.462832 | 0.704485 | 2.264870 | 0.845408 |
| Comparative Example 1 Full width at half maximum (FWHM) | 3.954496 | 3.429469 | 0.484673 | 0.748552 | 2.764585 | 0.908331 |

As shown in FIG. 7 and Table 2, the full width at half maximum of the stacked structure of Example 1 at each diffraction peak becomes smaller than that of the stacked structure of Comparative Example 1, revealing that the former one has higher crystallinity.

The arrow shown in FIG. 7 shows a peak shift of the diffraction peak of the stacked structure of Example 1 viewed from that of the stacked structure of Comparative Example 1.

The structural analysis of each of the stacked structures of Example 1 and Comparative Example 1 was performed using a scanning transmission electron microscope ("JEM-ARM200F", product of JEOL Ltd.).

First, the electron microscope image of the stacked structure of Example 1 is shown in FIG. 8.

As shown in FIG. 8, it has been confirmed clearly that the stacked structure of Example 1 has a space (refer to the dark-color horizontal line in the drawing) based on Van der Waals bonding between a structural unit of 9 atoms consisting of Ge₂Te₂ and Sb₂Te₃ and another structural unit adjacent thereto.

Further, it has been confirmed from the results of elemental mapping of a portion of the stacked structure of Example 1 by using an energy dispersible X-ray analyzer that a 5-atom layer consisting of Te-Sb-Te-Sb-Te has thereon a Ge-Te-Ge-Te layer, which coincides well with the atomic arrangement model shown in FIG. 1. This means that even if structural observation is performed by adding external energy, mutual diffusion between Ge atoms and Sb atoms is suppressed by the addition of S atoms and the stacked structure can keep original atomic arrangement.

Next, the electron microscope image of the stacked structure of Comparative Example 1 is shown in FIG. 9.

As shown in FIG. 9, it has been confirmed that the stacked structure of Comparative Example 1 becomes a uniform alloy as a result of mutual diffusion between Ge atoms and Sb atoms.

It has been confirmed from the comparison between the S-atom-added stacked structure of Example 1 and the S-atom-free stacked structure of Comparative Example 1 that a stacked structure having stable atomic arrangement can be obtained and diffusion of Ge atoms can be suppressed by the addition of S atoms.

### (Example 2)

In a manner similar to that of Example 1 except that the target material was changed from the S-atom-added GeTe alloy material (Ge₅₀Te₄₇S₃) to an Se-atom-added GeTe alloy material (Ge₅₀Te₄₇Se₃, product of Mitsubishi Materials Corporation, purity: 99.9%) and thereby Se atoms were added to the GeTe alloy layer, a stacked structure of Example 2 was manufactured.

Structural analysis of the stacked structure of Example 2 in a manner similar to that of Example 1 yielded analysis results similar to those of Example 1. It is thus confirmed that even if Se atoms are added instead of S atoms, a stacked structure having stable atomic arrangement can be obtained and diffusion of Ge atoms can be suppressed.

### (Comparative Example 2)

In a manner similar to that of Example 1 except that the target material was changed from the S-atom-added GeTe alloy material (Ge₅₀Te₄₇S₃) to an Al-atom-added GeTe alloy material (Ge₅₀Te₄₇Al₃, product of Mitsubishi Materials Corporation, purity: 99.9%) and thereby Al atoms were added to the GeTe alloy layer, a stacked structure of Comparative Example 2 was manufactured.

Structural analysis of the stacked structure of Comparative Example 2 in a manner similar to that of Comparative Example 1 yielded analysis results similar to those of S-atom-free Comparative Example 1. It has been confirmed that the Al-atom-added stacked structure of Comparative Example 2 becomes a uniform alloy as a result of mutual diffusion between Ge atoms and Sb atoms.

### (Comparative Example 3)

In a manner similar to that of Example 1 except that the target material was changed from the S-atom-added GeTe alloy material (Ge₅₀Te₄₇S₃) to an S-atom-free GeTe alloy material (product of Mitsubishi Materials Corporation, purity: 99.9%) and at the same time, sputtering was performed by adding an oxygen gas to a sputtering gas (Ar gas) at a gas flow rate ratio of 10:1 (Ar gas : oxygen gas) to add O atoms to the GeTe alloy layer, a stacked structure of Comparative Example 3 was manufactured.

Structural analysis of the stacked structure of Comparative Example 3 in a manner similar to that of Comparative Example 1 yielded analysis results similar to those of S-atom-free Comparative Example 1. It has been confirmed that the O-atom-added stacked structure of Comparative Example 3 becomes a uniform alloy as a result of mutual diffusion between Ge atoms and Sb atoms.

### (Comparative Example 4)

In a manner similar to that of Comparative Example 3 except that a nitrogen gas was used instead of the oxygen gas to add N atoms to the GeTe alloy layer, a stacked structure of Comparative Example 4 was manufactured.

Structural analysis of the stacked structure of Comparative Example 4 in a manner similar to that of Comparative Example 1 yielded analysis results similar to those of the S-atom-free structure of Comparative Example 1. It has been confirmed that the N-atom-added stacked structure of Comparative Example 4 becomes a uniform alloy as a result of mutual diffusion between Ge atoms and Sb atoms.

### [Semiconductor device]

### (Example 3)

A semiconductor device of Example 3 was manufactured according to the constitution of a semiconductor device 10 shown in FIG. 10. Specific manufacturing conditions will be described below. FIG. 10 is an explanatory view for explaining the constitution of the semiconductor device of Example 3.

As a structure on the bottom surface side of a stacked structure 18, that having, in a SiO₂ layer 12 on a silicon substrate 11, a lower electrode having a W layer 13 and a TiN layer 14 stacked successively in order of mention is used. The TiN layer 14 has a diameter of 90 nm.

An underlayer 15 formed of an Sb₂Te₃ alloy was formed, on the surface of the structure on which the TiN layer 14 was formed, in a manner similar to that used for the formation of the first Sb₂Te₃ alloy layer of the stacked structure of Example 1 except that the thickness was changed from 3.0 nm to 5.0 nm.

Next, a GeTe alloy layer 16 was formed on the underlayer 15 in a manner similar to that used for the formation of the first GeTe alloy layer of the stacked structure of Example 1.

Next, an Sb₂Te₃ alloy layer 17 was formed on the GeTe alloy layer 16 in a manner similar to that used for the formation of the second Sb₂Te₃ alloy layer of the stacked structure of Example 1 except that the thickness was changed from 1.0 nm to 4.0 nm.

Further, the GeTe alloy layer 16 and the Sb₂Te₃ alloy layer 17 were stacked alternately in repetition and a stacked structure 18 having eight GeTe alloy layers 16 and eight Sb₂Te₃ alloy layers 17 stacked alternately to have a stacked structure of 17 layers in total including the underlayer 15 was formed.

Finally, a TiN layer 19 was formed on the Sb₂Te₃ alloy layer 17 serving as the uppermost layer of the stacked structure 18 by sputtering with the sputtering apparatus while using Ti and N as a target (composition ratio: 1:1). The resulting TiN layer 19 serves as an upper electrode.

Thus, the semiconductor device of Example 3 was manufactured. In the semiconductor device of Example 3, the GeTe alloy layers 16 each contain S atoms at a concentration of 3 at%.

### (Comparative Example 5)

A semiconductor device of Comparative Example 5 was manufactured in a manner similar to that of Example 3 except that each of the GeTe alloy layers 16 was formed as in the formation of the S-atom-free GeTe layer of the stacked structure of Comparative Example 1.

### (Device properties)

Device properties of each of the semiconductor devices of Example 3 and Comparative Example 5 were measured by connecting an external power supply thereto and applying a voltage between the upper electrode and the lower electrode.

FIG. 11 shows a change in the voltage-electrical resistance characteristics of each of the semiconductor devices of Example 3 and Comparative Example 5 from a high-resistance state (RESET phase) to a low-resistance state (SET phase).

FIG. 12 shows a change in the voltage-electrical resistance characteristics of each of the semiconductor devices of Example 3 and Comparative Example 5 from a low-resistance state (SET phase) to a high-resistance state (RESET phase).

As shown in FIG. 11, it has been confirmed that there is no large difference between the semiconductor devices of Example 3 and Comparative Example 5 in the voltage-electrical resistance characteristics when a phase change is caused from the high-resistance state (RESET phase) to the low-resistance state (SET phase).

As shown in FIG. 12, on the other hand, a large difference has been confirmed between the semiconductor devices of Example 3 and Comparative Example 5 in the voltage-electrical resistance characteristics when a phase change is caused from the high-resistance state (RESET phase) to the low-resistance state (SET phase).

This means that the semiconductor device of Example 3 can cause a phase change at a voltage lower even by 39% than that of the semiconductor device of Comparative Example 5.

Although not shown in the drawing, the semiconductor device of Example 3 can cause a phase change at a current lower even by 27% than that of the semiconductor device of Comparative Example 5.

This suggests that since the original atomic arrangement of Sb atoms and Ge atoms can stably be retained in the semiconductor device of Example 3 due to the addition of S atoms even if external energy necessary for memory operation is applied, diffusion of Ge atoms is suppressed and further, the semiconductor device can exhibit and keep its original device properties (phase-change properties).

### Description of Reference Numerals

- 10:: Semiconductor device
- 11:: Silicon substrate
- 12:: SiO₂ layer
- 13:: W layer
- 14, 19:: TiN layer
- 15:: Underlayer
- 16:: GeTe Alloy layer
- 17:: Sb₂Te₃ Alloy layer
- 18:: Stacked structure.

## Claims

1. A stacked structure comprising:
an alloy layer A having germanium and tellurium as a main component thereof, and
an alloy layer B having tellurium and either of antimony or bismuth as a main component thereof, wherein:
at least either of the alloy layer A or the alloy layer B contains at least either of sulfur or selenium as a chalcogen atom.

2. The stacked structure according to Claim 1, wherein the chalcogen atom is contained in the alloy layer A.

3. The stacked structure according to Claim 1 or 2, wherein a chalcogen content of the alloy layer A is from 0.05 at% to 10.0 at%.

4. The stacked structure according to any of Claims 1 to 3, having the alloy layer A and the alloy layer B stacked alternately in repetition.

5. The stacked structure according to any of Claims 1 to 4, wherein the alloy layer A has a cubic crystal structure and the alloy layer B has a hexagonal crystal structure, the alloy layer A is stacked over the alloy layer B, the alloy layer B has a c axis oriented in a stacking direction, and the alloy layer A has a (111) face oriented to a surface adjacent to the alloy layer B.

6. A method of manufacturing the stacked structure as claimed in any of Claims 1 to 5, comprising a step of heating each of the alloy layer A and the alloy layer B at a temperature of from 200°C to 300°C.

7. A semiconductor device, comprising the stacked structure as claimed in any of Claims 1 to 5.
